# FASCICULE DE BREVET EUROPEEN

(11) **EP 2 484 629 B1**
(45) Date de publication et mention de la délivrance du brevet: **26.06.2013**
(21) Numéro de dépôt: 11153244.6
(22) Date de dépôt: 03.02.2011
(51) Int. Cl.: B81C 99/00

(54) **Pièce de micromécanique complexe ajourée**
Komplexes durchbrochenes mikromechanisches Bauteil
Perforated complex micromechanical part

(43) Date de publication de la demande: 08.08.2012
(73) Titulaire: Nivarox-FAR S.A., 2400 Le Locle (CH)
(72) Inventeur: Cusin, Pierre, 1423, Villars-Burquin (CH); Richard, David, 1400, Yverdon-les-Bains (CH); Dubois, Philippe, 2074, Marin (CH)
(74) Mandataire: Couillard, Yann Luc Raymond

(56) Documents cités:
- US-A- 6 015 599
- ALEXANDRE BONGRAIN ET AL: "Selective nucleation in silicon moulds for diamond MEMS fabrication", JOURNAL OF MICROMECHANICS & MICROENGINEERING, INSTITUTE OF PHYSICS PUBLISHING, BRISTOL, GB, vol. 19, no. 7, 1 juillet 2009 (2009-07-01), page 74015, XP020160890, ISSN: 0960-1317
- KARCZEMSKA A ET AL: "Diamond Microfluidic Devices manufactured with the replica method", PERSPECTIVE TECHNOLOGIES AND METHODS IN MEMS DESIGN, 2009. MEMSTECH 2009. 2009 5TH INTERNATIONAL CONFERENCE ON, IEEE, PISCATAWAY, NJ, USA, 22 avril 2009 (2009-04-22), pages 17-19, XP031471595, ISBN: 978-966-2191-06-6

## Description

### Domaine de l'invention

L'invention se rapporte à une pièce de micromécanique complexe fabriquée à partir d'un matériau quelconque comme par exemple à base de carbone ainsi qu'à un procédé de fabrication d'une telle pièce.

### Arrière plan de l'invention

La fabrication de pièce de micromécanique uniquement en diamant synthétique ou en DLC (abréviation provenant des termes anglais « Diamond Like Carbon ») est très chère et n'est pas tribologiquement favorable à cause de la rugosité défavorable générée par le processus de dépôt en couche épaisse ou par un procédé de gravage dans la masse. Par conséquent, actuellement, on pratique plutôt le revêtement de pièce de micromécanique à l'aide de diamant synthétique ou de DLC en fine couche sans toutefois pouvoir obtenir n'importe quelle forme notamment si une partie de la pièce doit être ajourée.

L'article d' ALEXANDRE BONGRAIN ET AL: "Sélective nucleation in silicon moulds for diamond MEMS fabrication", JOURNAL OF MICROMECHANICS & MICROENGINEERING, INSTITUTE OF PHYSICS PUBLISHING, BRISTOL, GB, décrit une technologie de nucléation sélective dans un moule. Ce procédé comporte une étape de déposer des particules sur le substrat destinées à former des lieux de germination. Ensuite, une couche sacrificielle est déposée et structurée en sorte qu'une partie du substrat est protégée. Une gravure enlève les particules non-protégées. Après, la couche en métal est retirée. Il s'ensuit le dépôt d'une couche en phase vapeur qui se dépose exclusivement où subsistent les particules. Quelques parties de la couche déposée sont libérées mais le moule n'est pas retiré complètement.

### Résumé de l'invention

Le but de la présente invention est de pallier tout ou partie les inconvénients cités précédemment en proposant un procédé de fabrication d'une pièce de micromécanique de géométrie complexe ajourée utilisant une quantité minimale de matériau et d'étapes permettant à la pièce d'avoir une rugosité très améliorée avec un taux de rebut et un coût de production très favorables.

A cet effet, l'invention se rapporte à un procédé de fabrication d'une pièce de micromécanique en un matériau monobloc caractérisé en ce qu'il comporte les étapes suivantes :
a) former un substrat comportant l'empreinte négative de ladite pièce de micromécanique à fabriquer ;
b) former une couche sacrificielle sur une partie du substrat ;
c) déposer des particules sur le substrat destinées à former des lieux de germination ;
d) retirer la couche sacrificielle afin de laisser sélectivement libre de toute particule, une partie du substrat ;
e) déposer une couche de matériau chimiquement en phase vapeur afin qu'elle se dépose exclusivement où subsistent les particules ;
f) retirer le substrat afin de laisser libre la pièce de micromécanique formée dans ladite empreinte négative.

On comprend donc que le procédé autorise la fabrication d'une pièce de micromécanique monobloc, c'est-à-dire sans discontinuité de matière, qui comporte une « peau » de matériau, c'est-à-dire peu de matériau, dont la surface externe reprend la rugosité très favorable du substrat. Cela permet de diminuer très sensiblement le coût du matériau voulu sur la couche externe et d'améliorer la rugosité globale, surtout au niveau de la surface externe, pour parfaire sa tribologie. De plus, la matière est sélectivement déposée en ne déposant que la quantité de matière nécessaire au revêtement final sans qu'une opération de retouche soit rendue nécessaire.

Conformément à d'autres caractéristiques avantageuses de l'invention :
- le procédé comporte, avant l'étape f), l'étape g) : retirer du substrat une épaisseur supérieure à celle de la couche déposée afin de laisser une épaisseur de ladite couche de matériau circonscrite dans ladite empreinte négative ;
- l'étape b) est réalisée par photolithographie ;
- l'étape c) comporte les phases 1) : enduire le substrat à l'aide d'une solution colloïdale comportant lesdites particules et 2) : retirer le solvant de la solution colloïdale pour ne laisser que les particules sur le substrat ;

- les particules sont de même nature que le matériau déposé lors de l'étape e) ;
- le matériau déposé lors de l'étape e) est formé à partir d'un composé à base de silicium ou à partie d'un allotrope du carbone ;
- le procédé comporte, après l'étape e), l'étape h) : remplir l'empreinte, revêtue du matériau déposé lors de l'étape e), avec un deuxième matériau afin d'obtenir une pièce de micromécanique en un premier matériau renforcé et/ou décoré par un deuxième matériau ;
- lors de l'étape h), le deuxième matériau est formé en saillie de ladite empreinte afin de former un élément fonctionnel supplémentaire à la pièce de micromécanique ;
- le deuxième matériau comporte un métal ou un alliage métallique.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 8 sont des représentations d'étapes successives d'un procédé de fabrication selon un premier mode de réalisation de l'invention ;
- la figure 9 est une représentation d'un exemple de pièce de micromécanique obtenue selon un premier mode de réalisation de l'invention ;
- les figures 10 à 14 sont des représentations d'étapes successives d'un procédé de fabrication selon un deuxième mode de réalisation de l'invention ;
- les figures 15 à 17 sont des représentations d'étapes successives d'un procédé de fabrication selon un troisième mode de réalisation de l'invention ;
- la figure 18 est une représentation d'un exemple de pièce de micromécanique obtenue selon un troisième mode de réalisation de l'invention ;
- les figures 19 et 20 sont des représentations d'étapes successives d'un procédé de fabrication selon un quatrième mode de réalisation de l'invention ;
- la figure 21 est une représentation d'un exemple de pièce de micromécanique obtenue selon un quatrième mode de réalisation de l'invention.

### Description détaillée des modes de réalisation préférés

L'invention se rapporte à un procédé de fabrication d'une pièce de micromécanique monobloc par exemple en un matériau à base de carbone. A base de carbone signifie un allotrope synthétique du carbone sous forme cristalline, comme du diamant ou une ou plusieurs couches de graphène, ou sous forme amorphe, comme du DLC (abréviation provenant des termes anglais « Diamond Like Carbon »).

Bien entendu, avantageusement selon l'invention, d'autres types de matériaux, qui sont déposables sous forme de couche et qui présentent un intérêt tribologique, peuvent être utilisés alternativement à un allotrope synthétique du carbone. Un tel matériau alternatif peut, par exemple, être un composé à base de silicium, c'est-à-dire par exemple du nitrure de silicium, de l'oxyde de silicium ou du carbure de silicium.

Cette pièce de micromécanique a été imaginée pour des applications dans le domaine horloger. Toutefois, d'autres domaines peuvent parfaitement être imaginés comme notamment l'aéronautique, la bijouterie ou l'automobile.

Dans le domaine horloger, cette pièce de micromécanique peut, à titre d'exemple, former une partie de l'habillage, le spiral, le balancier, l'ancre, les ponts ou même les mobiles comme les roues d'échappement totalement ou partiellement à base d'un allotrope synthétique du carbone ou d'un matériau alternatif comme expliqué ci-dessus.

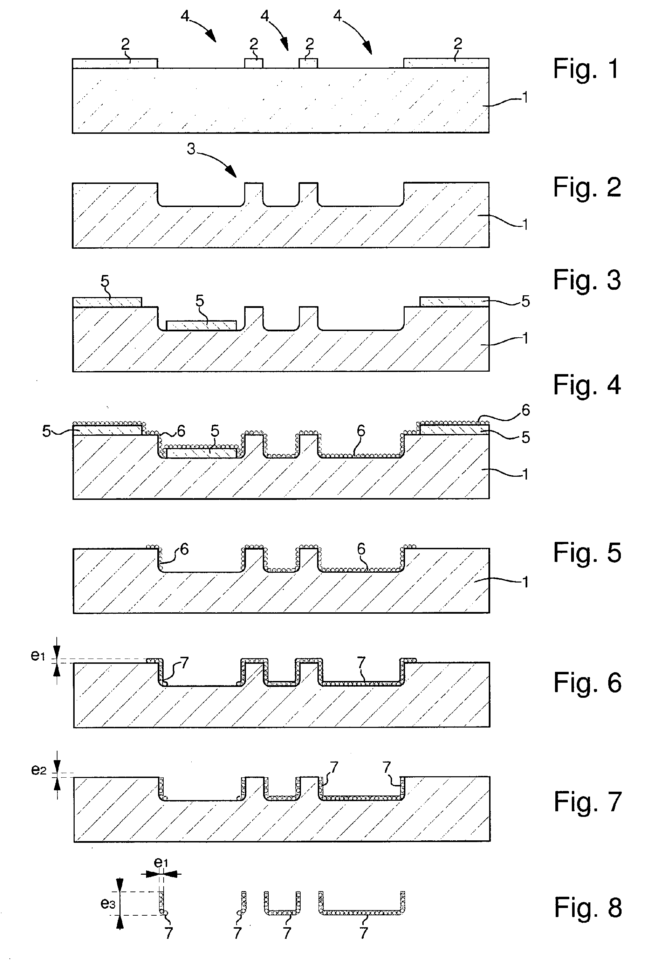

Un premier mode de réalisation d'un procédé de fabrication d'une telle pièce de micromécanique est présenté aux figures 1 à 8. Dans une étape a, le procédé consiste à former, dans un substrat 1, une empreinte 3 négative de la future pièce de micromécanique. Une grande variété de substrats 1 est possible. Préférentiellement, la matière du substrat 1 est choisie pour sa très faible rugosité, c'est-à-dire son caractère naturel à présenter une surface lisse mais également pour sa résistance quant à l'agressivité des étapes de dépôt.

A titre d'exemple, les figures 1 et 2 présentent l'étape a formée à partir d'un substrat 1 en silicium pour lequel il est possible d'obtenir une très bonne rugosité, c'est-à-dire un écart moyen arithmétique Rₐ sensiblement inférieur à 10 nm.

Ainsi, dans une première phase illustrée à la figure 1, le substrat 1 est revêtu d'un masque 2 présentant des ajourages 4 laissant non recouverte une partie supérieure du substrat 1. Dans une deuxième phase, un gravage selon les ajourages 4 est effectué. Un tel gravage peut être réalisé par une attaque sèche ou humide. Enfin, dans une troisième phase illustrée à la figure 2, le masque 2 est retiré pour ne laisser que l'empreinte 3 négative réalisée dans le substrat 1.

Dans une deuxième étape b illustrée à la figure 3, le substrat 1 est revêtu d'une couche sacrificielle 5 présentant des zones non recouverte du substrat 1. Préférentiellement, l'étape b est réalisée par une photolithographie d'une résine photosensible du type négatif ou positif.

Comme illustré à la figure 4, une troisième étape c consiste à recouvrir l'ensemble du substrat 1 de particules 6 destinées à former des lieux de germination pour le futur dépôt.

Préférentiellement, l'étape c comporte une première phase destinée à enduire le substrat 1 à l'aide d'une solution colloïdale comportant lesdites particules. L'enduction peut ainsi être obtenue par l'immersion au moins partielle du substrat 1 dans une solution dont les particules sont volontairement rendues mobiles dans le solvant afin d'obtenir une répartition la plus homogène possible dans la solution. A titre d'exemple, leur mobilité dans le solvant peut être apportée par une agitation du type à ultrasons. Enfin, sans être limitatif, le solvant peut consister en de l'alcool ou de l'eau.

Les particules 6 sont utilisées comme lieux de germination. A ce titre, les particules peuvent être des impuretés vis-à-vis du matériau du futur dépôt, tout comme elles peuvent être de la même nature que le matériau du futur dépôt. Préférentiellement, le diamètre des particules est compris entre quelques nanomètres à quelques dizaines de nanomètres.

L'étape c se poursuit avec une deuxième phase destinée à retirer le solvant de la solution pour former les particules 6 sur le substrat 1. Cette deuxième phase peut être par exemple obtenue par vaporisation du solvant.

Dans une quatrième étape d illustrée à la figure 5, le procédé consiste à retirer la couche sacrificielle 5 du substrat 1 afin de laisser sélectivement libre de toute particule 6, une partie du substrat 1. On comprend donc que les parties où figurent les particules 6 correspondent aux zones où n'était pas présente la couche sacrificielle 5. L'étape d peut, à titre non limitatif, être obtenue par une dissolution ou une attaque chimique sélective de la couche sacrificielle 5.

Dans une cinquième étape e du premier mode de réalisation, le procédé consiste à déposer un matériau 7 chimiquement en phase vapeur afin qu'il se dépose exclusivement où subsistent les particules 6. A la fin de l'étape e, comme illustré à la figure 6, on obtient un substrat 1 formé directement avec la couche partielle de matériau 7 désirée.

Le procédé selon l'invention peut comporter une sixième étape optionnelle g. L'étape g est destinée à retirer une partie du substrat 1 revêtu de la couche 7 afin de laisser une épaisseur de ladite couche 7 circonscrite dans ladite empreinte négative 3. Préférentiellement selon l'invention, on enlève une épaisseur e₂ du substrat 1 supérieure à celle e₁ de la couche 7 comme illustré à la figure 7. On comprend donc qu'à coup sûr, la couche 7 n'est plus présente que dans l'empreinte 3 du substrat 1.

Dans une dernière étape f du premier mode de réalisation, le procédé consiste à retirer le substrat 1 afin de libérer la pièce de micromécanique formée au moins partiellement dans l'empreinte 3. Par conséquent, dans l'exemple ci-dessus dans lequel le substrat 1 est en silicium, l'étape f peut consister en une attaque sélective du silicium. Cela peut, par exemple, être obtenu par une attaque chimique au moyen d'un bain comportant de l'hydroxyde de tétraméthylammonium (connu sous les abréviations TMAH et TMAOH).

A la fin de l'étape f, comme illustré à la figure 8, on obtient une pièce de micromécanique formée exclusivement par la couche 7 de géométrie au moins partiellement correspondante à l'empreinte 3. Avantageusement, la surface externe, c'est-à-dire la surface qui était directement en contact avec le substrat 1, comporte une très bonne rugosité, c'est-à-dire comparable à celle du substrat 1, et est, préférentiellement, utilisée comme surface de contact mécanique.

Enfin, pour une hauteur e₃ de la pièce de micromécanique comprise entre 10 µm et 500 µm, seule une épaisseur e₁ de la couche 7 comprise entre 0,2 µm et 20 µm est déposée. On comprend donc immédiatement les gains en coût de matière et en coût de production dû au temps raccourci de l'étape e de dépôt.

Ainsi, quelle que soit la complexité de la pièce de micromécanique, le procédé n'est pas plus difficile à mettre en oeuvre. A titre d'exemple, il n'est pas plus difficile de former une denture sur une paroi de l'empreinte 3 qui formera une denture correspondante sur la pièce de micromécanique.

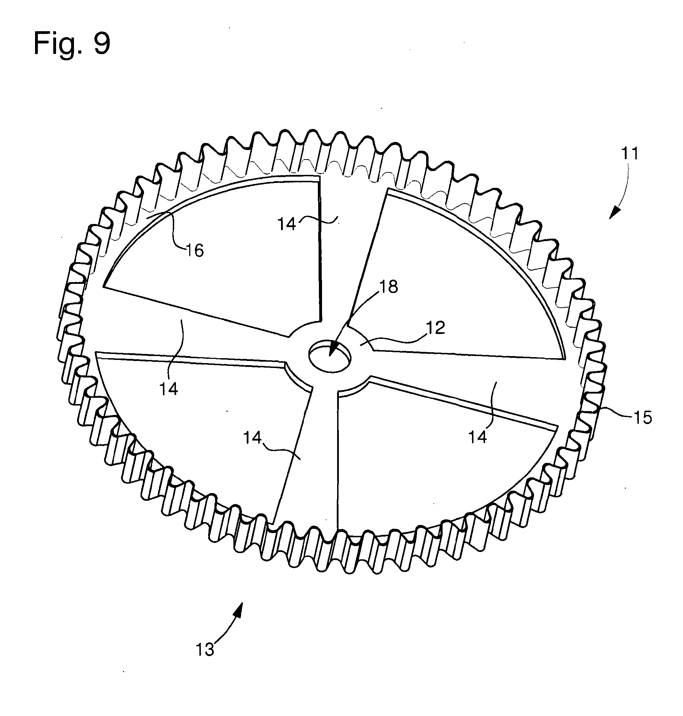

A titre d'exemple nullement limitatif, une pièce de micromécanique 11 susceptible d'être obtenue selon le premier mode de réalisation est présentée à la figure 9. La pièce de micromécanique 11 comporte une planche 13 sensiblement discoïdale dont le centre comporte un trou 18 autorisant la coopération par exemple avec un axe de pivotement. De plus, coaxialement au trou 18, s'étend un moyeu 12 reliant plusieurs bras 14 à la serge 16 à partir de la périphérie de laquelle se projette orthogonalement une denture 15. A la figure 9, on s'aperçoit donc que l'épaisseur de la denture 15 et de la planche 13 sont formées par l'épaisseur e₁ de la couche 7 déposée lors de l'étape e du procédé.

Avantageusement, la matière est sélectivement déposée en ne déposant que la quantité de matière nécessaire au revêtement final sans qu'une opération de retouche soit rendue nécessaire. ll en résulte un abaissement du taux de rebut qui était imputable à l'opération d'enlèvement de matière (détérioration du substrat 1, éclat sur le dépôt 7, etc.). Cela permet également un abaissement du coût de production généré par le raccourcissement de l'étape e de dépôt 7, de la moindre utilisation de matière du matériau 7 et de l'absence de l'opération d'enlèvement mécanique.

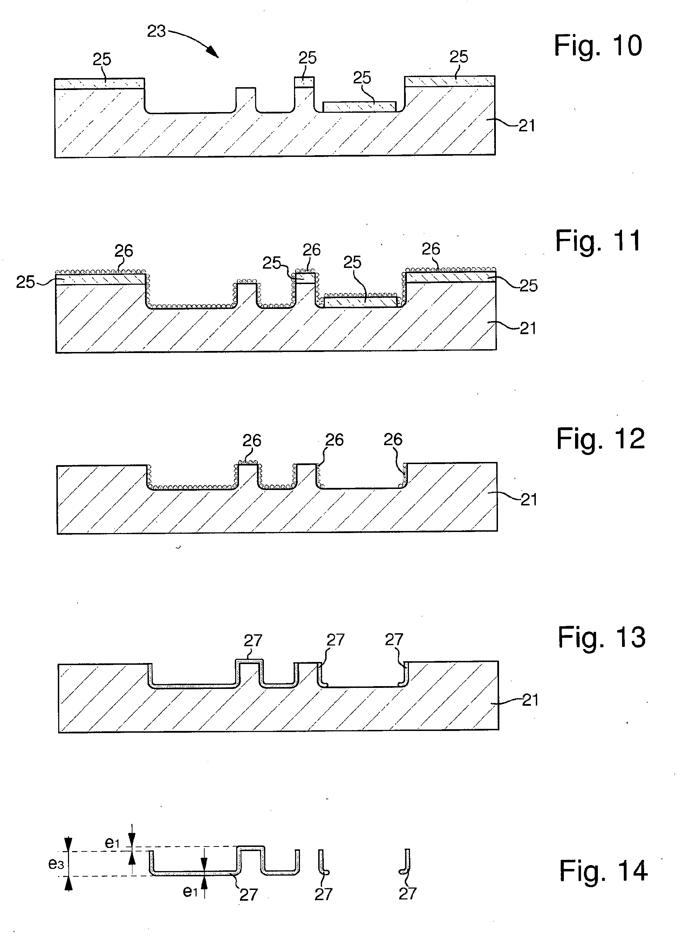

Un deuxième mode de réalisation alternatif au premier est présenté aux figures 10 à 14. L'étape a selon le deuxième mode de réalisation est identique au premier mode de réalisation et consiste à former, dans un substrat 21, une empreinte 23 négative de la future pièce de micromécanique avec les mêmes variantes et avantages que le premier mode de réalisation.

Dans une deuxième étape b illustrée à la figure 10, le substrat 21 est revêtu d'une couche sacrificielle 25 présentant des zones non recouverte du substrat 21. Préférentiellement, l'étape b est réalisée par une photolithographie d'une résine photosensible du type négatif ou positif.

Comme illustré à la figure 11, une troisième étape c consiste à recouvrir l'ensemble du substrat 21 de particules 26 destinées à former des lieux de germination pour le futur dépôt selon les mêmes variantes et avantages que l'étape c du premier mode de réalisation.

Dans une quatrième étape d illustrée à la figure 12, le procédé consiste à retirer la couche sacrificielle 25 du substrat 21 afin de laisser sélectivement libre de toute particule 26, une partie du substrat 21. On comprend donc que les parties où figurent les particules 26 correspondent aux zones où n'était pas présente la couche sacrificielle 25. L'étape d peut, à titre non limitatif, être obtenue par une dissolution ou une attaque chimique sélective de la couche sacrificielle 25.

Dans une cinquième étape e du deuxième mode de réalisation, le procédé consiste à déposer un matériau 27 chimiquement en phase vapeur afin qu'il se dépose exclusivement où subsistent les particules 26. A la fin de l'étape e, comme illustré à la figure 13, on obtient un substrat 21 formé directement avec la couche partielle de matériau 27 désirée.

Le procédé selon le deuxième mode de réalisation de l'invention peut comporter également une sixième étape g optionnelle identique à celle du premier mode de réalisation mais elle n'a pas été représentée.

Dans une dernière étape f du deuxième mode de réalisation, le procédé consiste à retirer le substrat 21 afin de libérer la pièce de micromécanique formée dans l'empreinte 23 avec les mêmes variantes et avantages que pour le premier mode de réalisation.

A la fin de l'étape f, comme illustré à la figure 14, on obtient une pièce de micromécanique formée exclusivement par la couche 27 de géométrie au moins partiellement correspondante à l'empreinte 23. Avantageusement, quand l'étape optionnelle g n'est pas réalisée, à la hauteur e₃ de la pièce de micromécanique du premier mode de réalisation peut s'ajouter une épaisseur e₁ de la couche 27 pour la hauteur totale comme illustré à la figure 14.

De plus, on comprend également, à l'aide du deuxième mode de réalisation, que l'étape g n'est pas rendue nécessaire pour circonscrire la couche 27 dans l'empreinte 23. En effet, il suffit de former une couche sacrificielle 25 partout sur le substrat 21 sauf au niveau de l'empreinte 23 pour obtenir le même résultat.

Ainsi, comme pour le premier mode de réalisation, quelle que soit la complexité de la pièce de micromécanique, le procédé n'est pas plus difficile à mettre en oeuvre. A titre d'exemple, il n'est pas plus difficile de former une denture sur une paroi de l'empreinte 23 qui formera une denture correspondante sur la pièce de micromécanique. Dès lors, on comprend que le deuxième mode de réalisation permet également de fabriquer la pièce de micromécanique 11 de la figure 9.

Par conséquent, dans le deuxième mode de réalisation comme dans le premier, on obtient une pièce de micromécanique formée exclusivement par la couche 27 de géométrie correspondante au moins à une partie de l'empreinte 23. Avantageusement, la surface externe, c'est-à-dire la surface qui était directement en contact avec le substrat 21, comporte une très bonne rugosité, c'est-à-dire comparable à celle du substrat 21, et est, préférentiellement, utilisée comme surface de contact mécanique.

De plus, de manière avantageuse dans le deuxième mode de réalisation, la matière est sélectivement déposée en n'utilisant que la quantité de matière nécessaire à la pièce finale sans qu'une opération de retouche soit rendue nécessaire. Il en résulte un abaissement du taux de rebut qui était imputable à l'opération d'enlèvement de matière (détérioration du substrat 21, éclat sur le dépôt 27, etc.). Cela permet également un abaissement du coût de production généré par le raccourcissement de l'étape e de dépôt, de la moindre utilisation de matière du matériau 27 et de l'absence de l'opération d'enlèvement mécanique.

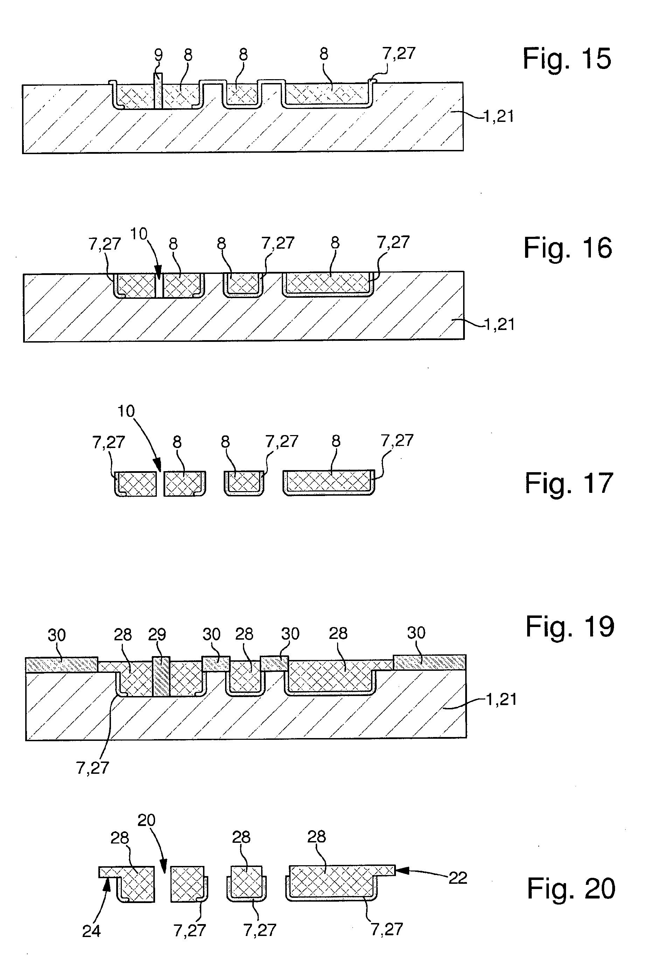

Un troisième mode de réalisation formant une alternative aux premier et deuxième modes de réalisation expliqués ci-dessus est présenté aux figures 15 à 17. Les étapes a à e restent identiques respectivement aux premier et deuxième modes de réalisation. Toutefois, comme illustré à la figure 15, une étape h est réalisée après l'étape e qui consiste à remplir le creux de l'empreinte 3, 23, revêtue du premier matériau 7, 27, avec un deuxième matériau 8.

Ainsi, éventuellement après l'étape optionnelle g et, après l'étape f, similaires aux premier et deuxième modes de réalisation, illustrées respectivement aux figures 16 et 17, on obtient une pièce de micromécanique en un premier matériau 7, 27 selon les mêmes variantes et avantages que les deux premiers modes de réalisation, le premier matériau 7, 27 étant en plus renforcé et/ou décoré par un deuxième matériau 8.

Selon un autre avantage de l'invention, il est désormais possible de recouvrir des pièces avec des couches minces qu'il n'était pas possible de fabriquer auparavant à cause des conditions particulières de dépôt de la couche mince comme, par exemple, la pression, la température ou les composés utilisés. A titre non limitatif, de manière avantageuse selon l'invention, il est ainsi possible de former une pièce principalement métallique à partir du dépôt 8 qui est revêtue d'une couche de diamant à partir de la couche 7, 27 alors qu'actuellement, il reste difficile à la connaissance de la Demanderesse de revêtir une pièce métallique avec du diamant.

Comme illustré à la figure 15, il est également possible préalablement à l'étape h de former une tige 9 afin que, lors de l'étape h, un trou 10 dénié de deuxième matériau 8 soit formé. On peut s'apercevoir qu'une fois la tige 9 retirée, la pièce finale est ainsi ajourée de part en part par un trou 10 comme illustré à la figure 17. A titre non limitatif, la tige 9 peut être formée par une photolithographie d'une résine photosensible du type négatif ou positif.

Préférentiellement, l'étape h de remplissage des creux est effectué par un dépôt galvanique ou une déformation à chaud. Le deuxième matériau est, de manière préférée, un métal ou un alliage métallique qui peut être ou non amorphe. Toutefois, rien n'empêche alternativement de changer le type de dépôt et/ou la nature du matériau déposé.

Par conséquent, dans ce troisième mode de réalisation, l'étape optionnelle g peut être utilisée pour circonscrire l'épaisseur de ladite couche 7, 27 dans ladite empreinte négative 3, 23 mais également à rendre plan le dépôt 8 du deuxième matériau par rapport à ladite partie circonscrite.

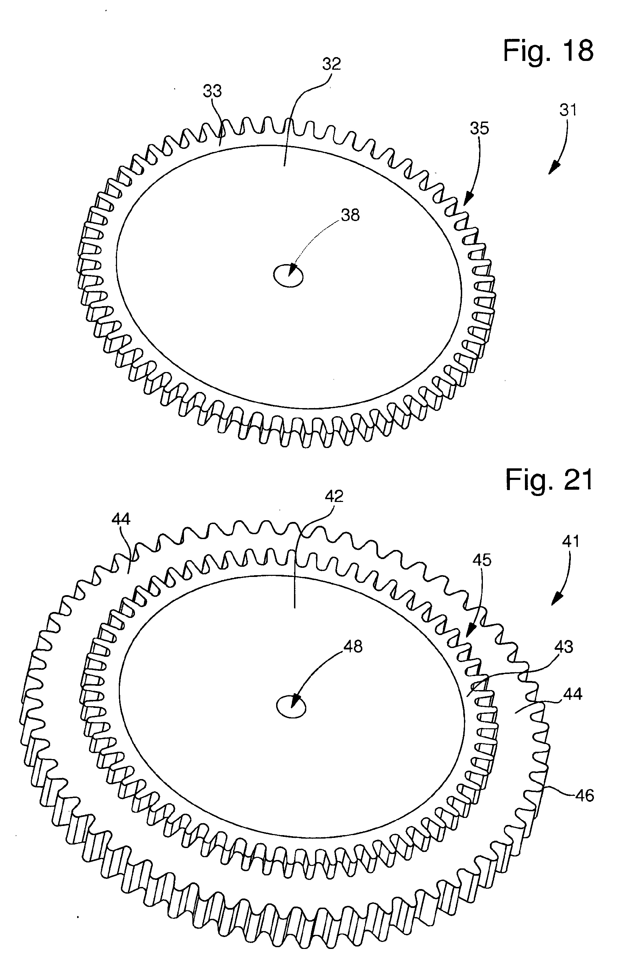

On comprend également que l'on peut obtenir une pièce de micromécanique selon les mêmes complexités que les deux premiers modes de réalisation. A titre d'exemple nullement limitatif, une pièce de micromécanique 31 susceptible d'être obtenue selon le troisième mode de réalisation est présentée à la figure 18. La pièce de micromécanique 31 comporte une planche 33 sensiblement annulaire à partir de la périphérie de laquelle se projette orthogonalement une denture 35, le reste étant comblé par la partie 32 formée par le dépôt 8 de l'étape h en laissant un trou 38 autorisant la coopération par exemple avec un axe de pivotement. L'épaisseur de la denture 35 est donc formée par l'épaisseur e₁ de la couche 7, 27 déposée lors de l'étape e du procédé ainsi que le dépôt 8 obtenu lors de l'étape h.

Un quatrième mode de réalisation alternatif aux premier et deuxième modes de réalisation expliqués ci-dessus est présenté aux figures 19 et 20. Les étapes a à e restent identiques aux premier et deuxième modes de réalisation. Toutefois, comme illustré à la figure 19, une sixième étape h est réalisée après l'étape e qui consiste à remplir le creux de l'empreinte 3, 23, revêtue du premier matériau 7, 27, avec un deuxième matériau 28. Ainsi, après l'étape f similaire aux trois premiers modes de réalisation et illustrée à la figure 20, on obtient une pièce de micromécanique en un premier matériau 7, 27 renforcé et/ou décoré par un deuxième matériau 28 selon les mêmes variantes et avantages que les trois premiers modes de réalisation.

Selon un avantage commun avec le troisième mode de réalisation, il est désormais possible de recouvrir des pièces avec des couches minces qu'il n'était pas possible de fabriquer auparavant à cause des conditions particulières de dépôt de la couche mince comme, par exemple, la pression, la température ou les composés utilisés. A titre non limitatif, de manière avantageuse selon le quatrième mode de réalisation de l'invention, il est ainsi possible de former une pièce principalement métallique à partir du dépôt 28 qui est revêtue d'une couche de diamant à partir de la couche 7, 27 alors qu'actuellement, il reste difficile à la connaissance de la Demanderesse de revêtir une pièce métallique avec du diamant.

En comparaison de l'étape h du troisième mode de réalisation, l'étape h selon le quatrième mode de réalisation est destinée à remplir le creux de l'empreinte 3, 23 et, avantageusement, permet également de former un niveau en saillie de l'épaisseur e₃ afin de former un élément fonctionnel supplémentaire à la pièce de micromécanique.

L'étape h selon le quatrième mode de réalisation comporte de manière préférée une phase de structuration d'un moule 30 sur le substrat 1, 21 après l'étape e. Puis une phase de remplissage de l'évidement formé conjointement par le creux de l'empreinte 3, 23 et les ajourages du moule 30. Enfin, l'étape h comporte une phase de retrait du moule 30 de la surface du substrat 1, 21.

La phase de structuration du moule 30 peut, à titre d'exemple, être formée à l'aide d'une photolithographie d'une résine photosensible du type négatif ou positif. De plus, la phase de remplissage peut, à titre d'exemple, être réalisée à l'aide d'une galvanoplastie. La galvanoplastie est d'autant plus facile à effectuer si le substrat 1, 21 est réalisé en un matériau conducteur comme du silicium fortement dopé. Le deuxième matériau est, de manière préférée, un métal ou un alliage métallique qui peut être ou non amorphe. Toutefois, rien n'empêche alternativement de changer le type de dépôt et/ou la nature du matériau déposé.

Comme illustré à la figure 19, il est également possible de former une tige 29 en même temps que le moule 30 afin que, lors de l'étape h, un trou 20 dénié de deuxième matériau 28 soit formé. On peut s'apercevoir qu'une fois la tige 29 retirée, la pièce finale est ainsi ajourée de part en part par un trou 20 comme illustré à la figure 20.

L'étape h peut également comporter une ultime phase de rodage et/ou de polissage de la partie supérieure du dépôt 28. Par conséquent, dans une dernière étape f du quatrième mode de réalisation, le procédé consiste à retirer le substrat 1, 21 afin de laisser libre la pièce de micromécanique formée au moins dans une partie de l'empreinte 3 avec les mêmes avantages que pour le premier mode de réalisation.

A la fin de l'étape f, comme illustré à la figure 20, on obtient une pièce de micromécanique formée par la couche 7, 27 de géométrie correspondante à au moins une partie de l'empreinte 3, 23, la couche 7, 27 étant renforcée et/ou décorée avec le dépôt 28. Avantageusement, la surface externe inférieure est formée par la couche 7, 27, c'est-à-dire la surface qui était directement en contact avec le substrat 1, 21, comporte une très bonne rugosité, c'est-à-dire comparable à celle du substrat 1, 21 et est, préférentiellement, utilisée comme surface de contact.

La pièce de micromécanique comporte également un deuxième niveau supérieur entièrement formé par le dépôt 28, c'est-à-dire sans couche 7, 27, afin de former un élément fonctionnel supplémentaire à la pièce de micromécanique. Cet élément fonctionnel peut, à titre non limitatif, être une denture 22, un trou 20 et/ou une portée 24 destinés, par exemple, à coopérer avec un autre organe.

Comme pour les trois premiers modes de réalisation, on comprend donc immédiatement le gain en coût de matière et en coût de production dû au temps raccourci de l'étape de dépôt de la couche 7, 27, le reste de la pièce étant formé par un dépôt 28 moins coûteux tout en offrant une géométrie qui peut être très complexe.

Par conséquent, on comprend que l'on peut obtenir une pièce de micromécanique selon la même complexité que les trois premiers modes de réalisation. A titre d'exemple nullement limitatif, une pièce de micromécanique 41 susceptible d'être obtenue selon le quatrième mode de réalisation est présentée à la figure 21. La pièce de micromécanique 41 comporte une planche 43 sensiblement annulaire, comparable à celle 33 de la figure 18, à partir de la périphérie de laquelle se projette orthogonalement une denture 45, le reste étant comblé par la partie 42 formée par le dépôt 28 de l'étape h en laissant un trou 48 autorisant la coopération par exemple avec un axe de pivotement. L'épaisseur de la denture 45 est donc formée par l'épaisseur e₁ de la couche 7, 27 déposée lors de l'étape e du procédé ainsi que le dépôt 28 obtenu lors de l'étape h. Sur un second niveau uniquement formé par le dépôt 28, la pièce de micromécanique 41 comporte une roue 44 dont la périphérie comporte une denture 46 et dont le centre comporte un trou prolongeant que le trou 48 destiné, par exemple, à coopérer avec un axe de pivotement.

Bien entendu, la présente invention ne se limite pas à l'exemple illustré mais est susceptible de diverses variantes et modifications qui apparaîtront à l'homme de l'art. En particulier, plusieurs pièces de micromécanique de motif identique ou non peuvent être fabriquées en même temps sur un même substrat. De plus, rien n'empêche d'utiliser la partie inférieure du substrat 1, 21.

Par conséquent, non seulement plusieurs empreintes 3, 23 identiques ou non peuvent être formées sur le substrat 1, 21 mais elles peuvent l'être également sur plusieurs faces du substrat 1, 21, c'est-à-dire que les étapes des différents modes de réalisation du procédé peuvent être appliquées à plusieurs faces du substrat 1, 21.

## Revendications

1. Procédé de fabrication d'une pièce de micromécanique (11, 31, 41) en un matériau monobloc **caractérisé en ce qu'**il comporte les étapes suivantes :
a) former un substrat (1, 21) comportant l'empreinte (3, 23) négative de ladite pièce de micromécanique à fabriquer ;
b) former une couche sacrificielle (5, 25) sur une partie du substrat (1, 21) ;
c) déposer des particules (6, 26) sur le substrat (1, 21) destinées à former des lieux de germination ;
d) retirer la couche sacrificielle (5, 25) afin de laisser sélectivement libre de toute particule (6, 26), une partie du substrat (1, 21) ;
e) déposer une couche de matériau (7, 27) chimiquement en phase vapeur afin qu'elle se dépose exclusivement où subsistent les particules (6, 26) ;
f) retirer le substrat (1, 21) afin de laisser libre la pièce de micromécanique (11, 31, 41) formée dans ladite empreinte négative.

2. Procédé selon la revendication précédente, **caractérisé en ce qu'**il comporte, avant l'étape f), l'étape suivante :
g) retirer du substrat (1, 21) une épaisseur supérieure (e₂) à celle (e₁) de la couche déposée (7, 27) afin de laisser une épaisseur de ladite couche de matériau circonscrite dans ladite empreinte négative.

3. Procédé selon l'une des revendications 1 ou 2, **caractérisé en ce que** l'étape b) est réalisée par photolithographie.

4. Procédé selon l'une des revendications précédentes, **caractérisé en ce que** l'étape c) comporte les phases suivantes :
1) enduire le substrat (1, 21) à l'aide d'une solution colloïdale comportant lesdites particules ;
2) retirer le solvant de la solution colloïdale pour ne laisser que les particules (6, 26) sur le substrat (1, 21).

5. Procédé selon l'une des revendications précédentes, **caractérisé en ce que** les particules (6, 26) sont de même nature que le matériau (7, 27) déposé lors de l'étape e).

6. Procédé selon l'une des revendications précédentes, **caractérisé en ce que** le matériau (7, 27) déposé lors de l'étape e) est formé à partir d'un allotrope du carbone.

7. Procédé selon l'une des revendications 1 à 5, **caractérisé en ce que** le matériau (7, 27) déposé lors de l'étape e) est formé à partir d'un composé à base de silicium.

8. Procédé selon l'une des revendications précédentes, **caractérisé en ce qu'**il comporte, après l'étape e), l'étape suivante :
h) remplir l'empreinte (3, 23), revêtue du matériau (7, 27) déposé lors de l'étape e), avec un deuxième matériau (8, 28) afin d'obtenir une pièce de micromécanique (31, 41) en un premier matériau (7, 27) renforcé et/ou décoré par un deuxième matériau (8, 28).

9. Procédé selon la revendication précédente, **caractérisé en ce que**, lors de l'étape h), le deuxième matériau (28) est formé en saillie de ladite empreinte afin de former un élément fonctionnel (20, 22, 24, 44) supplémentaire à la pièce de micromécanique (41).

10. Procédé selon la revendication 8 ou 9, **caractérisé en ce que** le deuxième matériau (8, 28) comporte un métal ou un alliage métallique.

## Patentansprüche

1. Verfahren für die Herstellung eines mikromechanischen Teils (11, 31, 41) aus einem Monoblock-Material, **dadurch gekennzeichnet, dass** es die folgenden Schritte umfasst:
a) Bilden eines Substrats (1, 21), das einen negativen Abdruck (3, 23) des herzustellenden mikromechanischen Teils aufweist;
b) Bilden einer Opferschicht (5, 25) auf einem Teil des Substrats (1, 21);
c) Ablagern von Partikeln (6, 26) auf dem Substrat (1, 21), die dazu bestimmt sind, Keimstellen zu bilden;
d) Entfernen der Opferschicht (5, 25), um einen Teil des Substrats (1, 21) wahlweise frei von jeglichem Partikel (6, 26) lassen;
e) chemisches Ablagern aus der Dampfphase einer Materialschicht (7, 27), damit sie sich ausschließlich dort abgelagert, wo die Partikel (6, 26) vorhanden sind;
f) Entfernen des Substrats (1, 21), um das in dem negativen Abdruck gebildete mikromechanische Teil (11, 31, 41) frei zu lassen.

2. Verfahren nach dem vorhergehenden Anspruch, **dadurch gekennzeichnet, dass** es vor dem Schritt f) den folgenden Schritt umfasst:
g) Abtragen einer Dicke (e₂), die größer als jene (e₁) der abgelagerten Schicht (7, 27) ist, von dem Substrat (1, 21), um eine Dicke der Materialschicht, die von dem negativen Abdruck umschrieben ist, zurückzulassen.

3. Verfahren nach einem der Ansprüche 1 oder 2, **dadurch gekennzeichnet, dass** der Schritt b) durch Photolithographie ausgeführt wird.

4. Verfahren nach einem der vorhergehenden Ansprüche, **dadurch gekennzeichnet, dass** der Schritt c) die folgenden Phasen umfasst:
1) Bestreichen des Substrats (1, 21) mithilfe einer kolloidalen Lösung, die die Partikel enthält;
2) Entfernen des Lösungsmittels aus der kolloidalen Lösung, um nur die Partikel (6, 26) auf dem Substrat (1, 21) zurückzulassen.

5. Verfahren nach einem der vorhergehenden Ansprüche, **dadurch gekennzeichnet, dass** die Partikel (6, 26) von der gleichen Art wie das im Schritt e) abgeleitete Material (7, 27) ist.

6. Verfahren nach einem der vorhergehenden Ansprüche, **dadurch gekennzeichnet, dass** das Material (7, 27), das im Schritt e) abgelagert wird, ausgehend von einem Kohlenstoffallotrop gebildet wird.

7. Verfahren nach einem der Ansprüche 1 bis 5, **dadurch gekennzeichnet, dass** das Material (7, 27), das im Schritt e) abgelagert wird, ausgehend von einer Verbindung auf Siliziumbasis gebildet wird.

8. Verfahren nach einem der vorhergehenden Ansprüche, **dadurch gekennzeichnet, dass** es nach dem Schritt e) den folgenden Schritt umfasst:
h) Befüllen des Abdrucks (3, 23), der mit dem Material (7, 27) beschichtet ist, das im Schritt e) abgelagert wird, mit einem zweiten Material (8, 28), um ein mikromechanisches Teil (31, 41) aus einem ersten Material (7, 27), das durch ein zweites Material (8, 28) verstärkt und/oder verziert ist, zu erhalten.

9. Verfahren nach dem vorhergehenden Anspruch, **dadurch gekennzeichnet, dass** im Schritt h) das zweite Material (28) so gebildet wird, dass es von dem Abdruck vorsteht, um zusätzlich zu dem mikromechanischen Teil (41) ein funktionales Element (20, 22, 24, 44) zu bilden.

10. Verfahren nach Anspruch 8 oder 9, **dadurch gekennzeichnet, dass** das zweite Material (8, 28) ein Metall oder eine Metalllegierung enthält.

## Claims

1. Method of fabricating a micromechanical part (11, 31, 41) in a single piece material **characterized in that** it includes the following steps:
a) forming a substrate (1, 21) which includes the negative cavity (3, 23) for said micromechanical part to be fabricated;
b) forming a sacrificial layer (5, 25) on one portion of the substrate (1, 21);
c) depositing particles (6, 26) on the substrate (1, 21) intended to form germination points;
d) removing the sacrificial layer (5, 25) so as to selectively leave one portion of the substrate (1, 21) free of any particles (6, 26);
e) depositing a layer of material (7, 27) by chemical vapour phase deposition so that the material is exclusively deposited where the particles (6, 26) remain;
f) Removing the substrate (1, 21) to release the micromechanical part (11, 31, 41) formed in said negative cavity.

2. Method according to the preceding claim, **characterized in that**, before step f), it includes the following step:
g) removing from the substrate (1, 21) a larger thickness (e₂) than that (e₁) of the deposited layer (7, 27), so as to leave a limited thickness of said layer of material in said negative cavity.

3. Method according to claim 1 or 2, **characterized in that** step b) is achieved by photolithography.

4. Method according to any of the preceding claims, **characterized in that** step c) includes the following phases:
1) coating the substrate (1, 21) using a colloidal solution including said particles;
2) removing the solvent from the colloidal solution to leave only the particles (6, 26) on the substrate (1, 21).

5. Method according to any of the preceding claims, **characterized in that** the particles (6, 26) are of the same nature as the material (7, 27) deposited in step e).

6. Method according to any of the preceding claims, **characterized in that** the material (7, 27) deposited in step e) is formed from a carbon allotrope.

7. Method according to any of claims 1 to 5, **characterized in that** the material (7, 27) deposited in step e) is formed from a silicon based compound.

8. Method according to any of the preceding claims, **characterized in that** after step e), it includes the following step:
h) filling the cavity (3, 23), coated with the material (7, 27) deposited in step e), with a second material (8, 28) in order to obtain a micromechanical part (31, 41) made of a first material (7, 27) reinforced and/or decorated with a second material (8, 28).

9. Method according to the preceding claim, **characterized in that**, in step h), the second material (28) is formed projecting from said cavity in order to form an additional functional element (20, 22, 24, 44) of the micromechanical part (41).

10. Method according to claim 8 or 9, **characterized in that** the second material (8, 28) includes a metal or metal alloy.
